Europäisches Patentamt

European Patent Office

Office européen des brevets

(19)

(11) Veröffentlichungsnummer: **0 141 279**

**A2**

# (12) EUROPÄISCHE PATENTANMELDUNG

(21) Anmeldenummer: **84111809.4**

(22) Anmeldetag: **03.10.84**

(51) Int. Cl.⁴: **H 05 K 13/00**

(30) Priorität: **20.10.83 DE 3338173**

(43) Veröffentlichungstag der Anmeldung:
**15.05.85 Patentblatt 85/20**

(84) Benannte Vertragsstaaten:
**AT BE CH DE FR GB IT LI LU NL SE**

(71) Anmelder: **Lemmer, Alfred**
**Machtlfingerstrasse 24**
**D-8000 München 70(DE)**

(72) Erfinder: **Lemmer, Alfred**
**Machtlfingerstrasse 24**
**D-8000 München 70(DE)**

(74) Vertreter: **Schmidt-Evers, Jürgen, Dipl.-Ing. et al,**
**Patentanwälte Dipl.-Ing. H. Mitscherlich Dipl.-Ing. K.**
**Gunschmann Dipl.-Ing. Dr.rer.nat. W. Körber Dipl.-Ing. J.**
**Schmidt-Evers Dipl.-Ing. W. Melzer Steinsdorfstrasse 10**
**D-8000 München 22(DE)**

(54) **Schneidvorrichtung zum Abschneiden der unten aus einer Leiterplatte herausragenden Anschlussdraht-Enden von Bauelementen.**

(57) Die Erfindung betrifft eine Schneidvorrichtung zum Abschneiden der aus einer Leiterplate herausragenden Anschlußdraht-Enden von Bauelementen, mit einer von den Anschlußdraht-Enden in einer Perforation durchfaßten Schneidplatte und einem Schermesser, zwischen denen eine Relativverschiebung stattfindet, und verfolgt den Zweck, die Schneidleistung und -sicherheit des Schermessers bei Wahrung der durch einen vorhandenen Freiwinkel des Schermessers bedingten guten Schneidwirkung zu erhöhen.

Dies wird dadurch erreicht, daß das Schermesser auf seiner Rückseite eine weitere Schneide aufweist, und daß dem Schermesser ein Schwenkmechanismus zugeordnet ist, mit dem wahlweise die eine oder die andere Schneide an die Schneidplatte schwenkbar und in dieser Schwenkstellung haltbar ist.

FIG. 3

Schneidvorrichtung zum Abschneiden der unten aus
einer Leiterplatte herausragenden Anschlußdraht-Enden
von Bauelementen.

------------------------------------------------

Die Erfindung bezieht sich auf eine Vorrichtung nach
dem Oberbegriff des Anspruches 1. Eine Vorrichtung
dieser Bauart ist in der DE-PS 27 24 143 beschrieben
und dargestellt. Diese bekannte Vorrichtung hat sich
in der Praxis bewährt.

Der Erfindung liegt die Aufgabe zugrunde, eine Schneidvorrichtung der vorliegenden Bauart so auszugestalten,
daß eine erhöhte Schneidleistung und -sicherheit bei
Wahrung der durch den Freiwinkel an der Schneide bedingten guten Schneidwirkung erreichbar ist.

Diese Aufgabe wird durch eine Ausgestaltung nach
Anspruch 1 gelöst. Während bei der bekannten Schneidvorrichtung Schneidarbeit nur während der Verschiebung
in eine  Richtung, nämlich beim Vorhub, verrichtet
werden kann, ist eine erfindungsgemäß ausgestaltete
Schneidvorrichtung in der Lage, sowohl beim Vorhub
als auch beim Rückhub Schneidarbeit zu verrichten,
so daß etwa eine Verdoppelung der Schneidleistung
erreichbar ist. Dabei wird das bewährte Schneidprinzip
beibehalten, nämlich ein Schermesser, daß unter Wahrung
eines Freiwinkels mit seiner Schneide an der Schneidplatte anliegt und sich dieser anzupassen vermag.

0141279

Obwohl die Schneidwirkung der bekannten Vorrichtung gut ist, ist nicht auszuschließen, daß hin und wieder ein Anschlußdraht-Ende beim Schneidvorgang umbiegt, ohne abgeschnitten zu werden. Die Schneidsicherheit solchen umgebogenen Anschlußdraht-Enden gegenüber ist bei der bekannten Schneidvorrichtung verbesserungswürdig, weil beim erneuten Vorschieben des Schermessers in die gleiche Schneidrichtung das Schermesser dazu neigt, über die umgebogenen Anschlußdraht-Enden zu rutschen.

Dagegen ist die Schneidsicherheit einer erfindungsgemäß ausgestalteten Schneidvorrichtung auch solchen umgebogenen Anschlußdraht-Enden gegenüber hervorragend, weil sie die umgebogenen Anschlußdraht-Enden von ihren freien Enden her schneidet. Dabei setzen die umgebogenen Anschlußdraht-Enden dem Schermesser einen erhöhten Widerstand entgegen, der in diesem Fall der Schneidwirkung zugute kommt, so daß die umgebogenen Anschlußdraht-Enden problemlos abgeschnitten werden können.

Aus der vorbekannten US-PS 3 3o7 442 ist zwar schon ein zweischneidiges Schermesser beschrieben und dargestellt, jedoch ist die Verrichtung von Schneidarbeit beim Rückhub des Schermessers nicht offenbart. Ob ein solcher Sachverhalt zu unterstellen ist, mag dahingestellt bleiben, weil die Bauart dieses bekannten Schermessers sich von der vorliegenden Bauart wesentlich unterscheidet und aus folgenden Gründen nachteilig ist. Aufgrund der flächigen Anlage des bekannten Schermessers an der Schneidplatte ist die dichte Anlage der Schneide an der Schneidplatte nicht gewährleistet. Schon geringe Unebenheiten an der Unterseite der Schneidplatte führen dazu, daß die

0141279

Schneidkante ihren Kontakt mit der Schneidplatte verliert, was schnell zu einem zu großen Spalt zwischen Schneidplatte und Schneide führen kann, wodurch ein Abschneiden der Anschlußdraht-Enden zu bezweifeln ist und vielmehr befürchtet werden muß, daß die Anschlußdraht-Enden umbiegen, ohne abgeschnitten zu werden. Die Ursache für vorbeschriebene Schwierigkeiten können eine unebene Unterseite der Schneidplatte selbst, eine unebene Oberseite des Schermessers, Schneidgrad, Abrieb und z.B. auch Verschmutzung sein. Ein Schwenkmechanismus für das Schermesser ist in diesem Stand der Technik nicht offenbart.

Zur Verwirklichung der Verschwenkung bei einer erfindungsgemäßen Ausgestaltung empfiehlt es sich, die Schwenkachse etwa auf Messermitte anzuordnen. Hierdurch ergeben sich für beide Schneiden etwa gleich große Schwenkwege und gleiche Schneidbedingungen aufgrund gleicher Schnittwinkel.

Durch eine Ausgestaltung nach Anspruch 3 wird verhindert, daß Anschlußdraht-Enden in die Stoßfuge geraten und dort verklemmen können.

Für ein sicheres und sauberes Abschneiden der Anschlußdraht-Enden ist eine exakte Anlage der Schneide an der Schneidplatte wichtig. Diese Forderung wird durch die Ausgestaltungen nach den Ansprüchen 4 und 11 erfüllt.

Im Anspruch 6 ist eine einfache, vorteilhafte Ausgestaltungsform für eine vorgenannte Pendellagerung enthalten, die durch eine günstige Anordnung der einzelnen Bauteile zueinander bestimmt ist. Eine kugelabschnittförmige Schraubenkopffläche führt zu einer gleichmäßigen Anlage am Schraubenkopf.

Die Ausführungsformen nach den Ansprüchen 7 bis 1o ergeben einen einfachen Schwenkmechanismus für das Messer oder Teilmesser, wobei gemäß Anspruch 8 ein Abrollen der Federplatte gewährleistet ist. Der Anspruch 9 ist aus Montagegründen vorteilhaft auszuführen.

Die Ausführungsform nach Anspruch 12 ist aus Herstellungskostengründen vorteilhaft und kennzeichnet sich durch Unempfindlichkeit aus.

Die Ausgestaltungen nach den Ansprüchen 13 bis 15 ermöglichen ein einfaches und leichtes bzw. ein automatisches Umschwenken des Messers oder der Teilmesser, was insbesondere im Hinblick auf Bedienungsfreundlichkeit und Leistung der Schneidvorrichtung vorteilhaft ist.

Gemäß den Ansprüchen 16 bis 18 ist zum Umschwenken des Messers oder der Teilmesser ein einfacher und unempfindlicher Schnappmechanismus vorgesehen.

Die Ansprüche 19 bis 21 beziehen sich darauf, die Schwenkendstellungen der durch Messer, Federplatte, Federn und Steuernocken gebildeten Schwenkeinheit einstellbar auszuführen, um den Andruck mit dem die betreffende Schneide gegen die Schneidplatte gedrückt wird, beeinflussen zu können. Die Einzelheiten ergeben praktische Ausführungsformen.

Gemäß Anspruch 22 ist eine für alle Teilmesser gemeinsame Federplatte vorgesehen, wodurch die Schwenkeinheit natürlich erheblich vereinfacht ist. Im Rahmen der Erfindung ist es jedoch auch möglich, jedem Teilmesser eine separate Federplatte und einen separaten Schnappmechanismus zuzuordnen, um z.B. bei langen Messern ungenutzte Teilmesser vom Umschwenken freizustellen.

Beim Vergleich mit dem Stand der Technik läßt sich erkennen, daß bei einer erfindungsgemäß ausgestalteten Vorrichtung ein im Sinne des Anspruches 23 wenigstens um die Messerbreite vergrößerter Schneidhub erforderlich ist, um die jeweilige Schneide hinter die mit Bauelementen bestückte Fläche zu setzen.

Nachfolgend wird ein Ausführungsbeispiel der Erfindung anhand einer vereinfachten Zeichnung näher beschrieben.

Es zeigen:

Figur 1 einen lotrechten Längsschnitt durch eine Schneidvorrichtung nach Linie I-I in Figur 2,

Figur 2 einen horizontalen Schnitt durch die Schneidvorrichtung nach der Linie II-II in Fig. 1 und

Figur 3 einen Teilschnitt nach der Linie III-III in Figur 2.

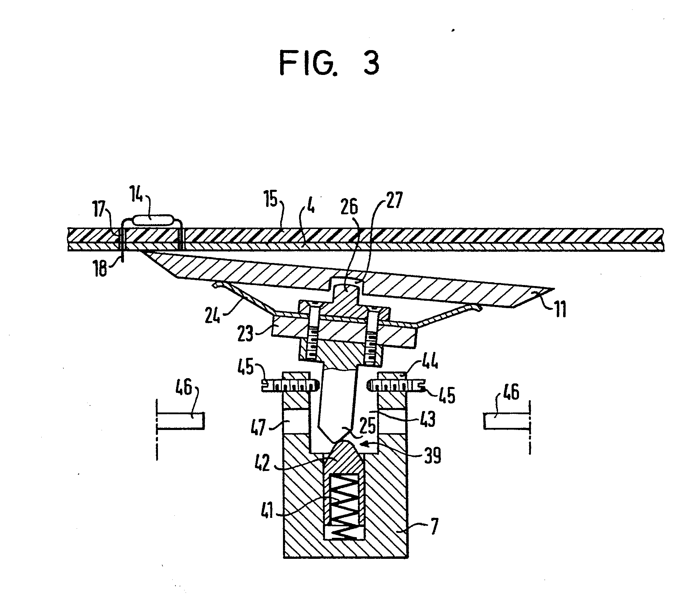

Die allgemein mit 1 bezeichnete Schneidvorrichtung umfaßt einen Rahmen 2 in der Form eines Tisches, unter dessen oberseitiger Platte 3 eine Schneidplatte 4 befestigt ist, zwei im Rahmen 2 gehaltene Führungsstangen 5, einen darauf mittels eines Zahnstangenantrieb 6 verschiebbaren Verschiebeblock 7 und eine

0141279

vom Verschiebeblock 7 getragene Schwenkeinheit 8, die ein aus drei Teilmessern 9 zusammengesetztes Messer 11 aufweist. In dem Zahnstangenantrieb 6 ist eine Rutschkupplung 12 integriert. In der Platte 3 befindet sich eine Ausnehmung 13, in die eine mit Bauelementen 14 bestückte Leiterplatte 15 einsetzbar ist. Die Anschlußdrähte 16 durchfassen eine nur in Figur 3 erkennbare Perforation der Schneidplatte 4 und ragen unterseitig aus der Schneidplatte heraus. Das Raster der Perforation 17 der Schneidplatte 4 stimmt mit dem Raster der Leiterplatte 15 überein.

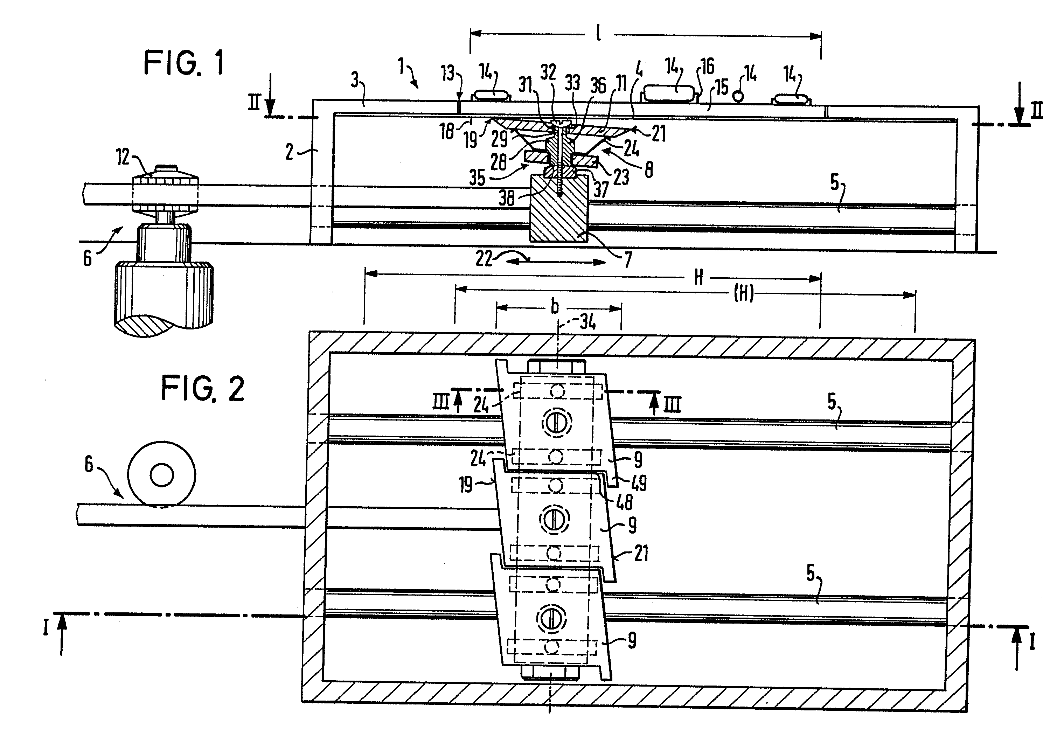

Beim Hin- und Herschieben des Verschiebeblocks 7 mittels des Zahnstangenantriebes 6 werden die aus der Schneidplatte 4 herausragenden Anschlußdraht-Enden 18 abgeschnitten. Bei jeder Verschiebung führt das Messer 11 folglich einen Schneidhub aus. Die Anschläge für den Verschiebeblock 7 bzw. die Verschiebeendstellungen sind nicht dargestellt. Wenn mit beiden Schneiden 19,21 des Messers 11 gearbeitet werden soll, ist der Schneidhub H wenigstens um das Maß der Messerbreite b größer zu bemessen, als die Länge 1 der Bestückungsfläche der Leiterplatte 15. Im Hinblick auf Figur 1 ist folglich die Schneide 19 hinter die rechte Seite der Leiterplatte 15 und die Schneide 21 hinter die linke Seite der Leiterplatte 15 zu verschieben, so daß die jeweilige Schneide 19,21 die gesamte Bestückungsfläche zu bestreichen vermag.

In der in Figur 1 dargestellten Position ist die Schneidvorrichtung 22 nach links gerichtet. Vor Beginn des entgegengesetzten Schneidhubes ist die Schneide 21 in Schneidposition zu bringen. Hierzu wird die Schwenkeinheit 8 in eine spiegelbildliche Position verschwenkt, so daß die Schneide 19 einen Abstand von der Schneidplatte 4 aufweist und die Schneide 21 an der Schneid-

platte 4 ggf. unter Berücksichtigung eines Schneidspaltes anliegt.

Die Schwenkeinheit 8 besteht aus einer sich unter den drei Teilmessern 9 erstreckenden Federplatte 23, auf der Federplatte 23 befestigten U-förmigen Blattfedern 24, den Teilmessern 9, zwei unterseitig an der Federplatte 23 befestigten Steuernocken 25 und je Teilmesser 9 zwei oberseitig an der Federplatte 23 befestigten Fixierungsstiften 26, die in unterseitige Ausnehmungen 27 der Teilmesser 9 mit Bewegungsspiel einfassen, um die Teilmesser 9 an einer Verdrehung parallel zur Schneidplatte 4 zu hindern.

Die Teilmesser 9 sind jeweils allseitig frei pendelnd auf jeweils einem Stützbolzen 28 gelagert. Hierzu greift jeweils ein Schaft 29 des Stützbolzens 28 mit allseitigem Bewegungsspiel in eine Ausnehmung 31 des Teilmessers 9 ein. Von oben ist jedes Teilmesser 9 durch einen Schraubenbolzen 32 gehalten, dessen den Teilmessern 9 zugewandte Kopffläche 33 kugelabschnittförmig gerundet ist. Aufgrund dieser Ausgestaltung vermag jedes Teilmesser 9 sich mit seiner jeweiligen Schneide 19,21 der Schneidplatte 4 anzupassen, gegen die es durch vier freie Enden der Blattfedern 24 beaufschlagt ist.

Die Federplatte 23 ist um eine quer zum Schneidhub H 22 und parallel zur Schneidplatte 4 gerichtete Achse 34 schwenkbar innerhalb von Einschnürungen 35 der Stützbolzen 28 gelagert. Die Stützbolzen 28 sind im Bereich der Einschnürungen 35 in jeweils ein Stützbolzenoberteil 36 und ein Stützbolzenunterteil 37 geteilt, wobei jeweils die untere Begrenzung der Einschnürung 35 durch eine zylinderabschnittförmig gekrümmte Teilungsfuge gebildet ist. Die Federplatte 23 38 vermag somit innerhalb der Einschnürungen 35 auf den gekrümmten Flächen der Teilungsfugen 38 zu schwenken, wobei sie auf den gekrümmten Flächen abrollt. Wenn die gekrümmten Flächen nicht vorhanden wären, würde die Federplatte um die Außenkanten der Stützbolzen 28 schwenken, was zu einer verzerrten, unerwünschten Schwenkbewegung führen würde.

Der Steuernocken 25 ist Teil eines in Figur 3 im einzelnen dargestellten Schnappmechanismusses 39, der einen im Verschiebeblock 7 vertikal verschiebbar gelagerten und mittels einer Feder 41 in Richtung auf den Steuernocken 25 vorgespannten Federnocken 42 umfaßt, der den Steuernocken 25 entweder in die linke oder in die rechte Schwenkendstellung zu schwenken sucht. Dabei faßt der Steuernocken 25 in eine oberseitig in den Verschiebeblock 7 eingearbeitete Ausnehmung 43, in der seine maximale Schwenkbewegung durch Seitenwände 44 des Verschiebeblocks 7 begrenzt ist. Um den Andruck, mit dem die jeweilige Schneide 19,21 gegen die Schneidplatte 4 beaufschlagt wird, beeinflussen zu können, befinden sich in den Seitenwänden 44 durch Gewindeschrauben gebildete verstellbare Anschläge 45 für den Steuernocken 25.

Das Umschwenken der Teilmesser 9 bzw. der Schwenkeinheit 8 nach jedem Schneidhub 22 erfolgt durch am Rahmen 2 befestigte, bevorzugt ebenfalls verstellbare Anschläge 46, die in jeder Hubendstellung durch Löcher 47 in den Seitenwänden 44 hindurch den Steuernocken 25 beaufschlagen und über den Totpunkt (Federnocken 42) schwenken.

Die vorbeschriebene Schneidvorrichtung eignet sich natürlich auch für eine Arbeitsweise nach dem Stand der Technik, bei der der Schneidhub nur in einer

0141279

Richtung erfolgt. Hierzu bedarf es lediglich einer Entnahme der Anschläge 46.

Um zu verhindern, daß während des Schneidens Anschlußdraht-Enden 18 in die zwischen benachbarten Teil-Schermessern 9 bestehende Stoßfuge 48 hineingeraten können und dort festklemmen, weisen die Teil-Schermesser 9 jeweils an ihrer Schneide 19,21 einen seitlichen Vorsprung 49 auf, mit dem sie die Schneide 19,21 des benachbarten Teil-Schermessers 9 übergreifen. Die Stoßfuge 48 ist somit in Schneidrichtung 22 verschlossen, und gegen das Eindringen eines Anschlußdraht-Endes 18 geschützt.

–1–

ANSPRÜCHE

1) Schneidvorrichtung zum Abschneiden der unten aus einer Leiterplatte herausragenden Anschlußdraht-Enden von Bauelementen, mit denen die Leiterplatte bestückt worden ist, mit einem Rahmen zur Aufnahme der Leiterplatte, einer an dem Rahmen vorgesehenen Schneidplatte, die mit einer Perforation zum Hindurchstecken der Anschlußdraht-Enden der Leiterplatte versehen ist, und mit einem relativ gegenüber der Schneidplatte verschiebbaren Schermesser, welches eine Schneide aufweist, die unter Wahrung eines Freiwinkels an der Unterseite der Schneidplatte anliegt, dadurch gekennzeichnet, daß das Schermesser (9,11) auf seiner Rückseite eine weitere Schneide (19,21) aufweist, und daß dem Schermesser (9,11) ein Schwenkmechanismus (Schwenkeinheit 8) zugeordnet ist, mit dem wahlweise die eine oder die andere Schneide (19,21) an die Schneidplatte (4) schwenkbar und in dieser Schwenkstellung haltbar ist.

2) Schneidvorrichtung nach Anspruch 1, dadurch gekennzeichnet, daß das Schermesser (9,11) um eine etwa in seiner Längsmitte oder Längsmitten-Querebene verlaufenden Achse (34) schwenkbar ist.

3) Schneidvorrichtung insbesondere nach Anspruch 1 oder 2, wobei das Schermesser in mehrere, nebeneinander angeordnete Teil-Schermesser unterteilt ist, dadurch gekennzeichnet, daß die Stoßfuge (48) zwischen benachbarten Teil-Schermessern (11) in der jeweiligen Schneidrichtung (22) von einem seitlichen Vorsprung (49) eines dieser beiden Teil-Schermesser (9) überdeckt ist, dessen Vorderseite eine Verlängerung der Schneide (19,21) des Teil-Schermessers (9) bildet, von dem er ausgeht, und dessen Rückseite parallel zur Schneide (19,21) des anderen Teil-Schermessers (9) gerichtet ist.

4) Schneidvorrichtung nach einem der Ansprüche 1 bis 3, dadurch gekennzeichnet, daß das Schermesser (11) oder die Teil-Schermesser (9) jeweils allseitig frei pendelnd auf einem etwa mittigen Stützbolzen (28) oder dergleichen gelagert sind.

5) Schneidvorrichtung nach Anspruch 3 , dadurch gekennzeichnet, daß das Schermesser (11) oder die Teil-Schermesser (9) um ihre Lagerstelle (Stützbolzen 28) rotationssymmetrisch ausgebildet sind.

6) Schneidvorrichtung nach Anspruch 4 oder 5, wobei der Stützbolzen auf einem Verschiebeblock befestigt ist und das Schermesser oder die Teil-Schermesser jeweils durch einen Schraubenbolzen oder dergleichen gehalten sind, der das betreffende Teil-Schermesser und den Stützbolzen durchfaßt, dadurch gekennzeichnet, daß der Stützbolzen (28) senkrecht auf dem Verschiebeblock (7) angeordnet ist und mit einem Schaft (29) in das Schermesser (11) oder betreffende Teil-Schermesser (9) mit allseitigem Bewegungsspiel einfaßt und die dem Schermesser (11) oder Teil-Schermesser (9) zugewandte Kopffläche (33) des Schraubenbolzens (32) bevorzugt eine Kugelabschnittsform aufweist.

7) Schneidvorrichtung nach einem der Ansprüche 1 bis 6, wobei das Schermesser oder die Teil-Schermesser durch Federn gegen die Schneidplatte beaufschlagt sind, dadurch gekennzeichnet, daß die Federn (Blattfedern 24) auf einer Federplatte (23) abgestützt sind, die um eine senkrecht zur Schneidrichtung (22) und parallel zur Schneidplatte (4) verlaufende Achse (34) schwenkbar an dem oder den Stützbolzen (28) gelagert ist.

8) Schneidvorrichtung nach Anspruch 7, dadurch gekennzeichnet, daß die den Federn (24) abgewandte Seite der Federplatte (23) auf einer zylinderförmig gekrümmten Fläche (Teilungsfuge 38) lagert.

9) Schneidvorrichtung nach Anspruch 8, dadurch gekennzeichnet, daß die zylinderförmig gekrümmte Fläche (Teilungsfuge 38) Teilungsfläche zwischen einem Stützbolzenoberteil (36) und einem Stützbolzenunterteil (37) ist.

1o) Schneidvorrichtung nach Anspruch 9, dadurch gekennzeichnet, daß die Lagerstelle für die Federplatte (23) durch Einschnürungen (35) in den Stützbolzenoberteilen (36) gebildet ist, die die Federplatte (23) mit einem ein Schwenken der Federplatte ermöglichendem Spiel durchfassen.

11) Schneidvorrichtung nach einem der Ansprüche 7 bis 1o dadurch gekennzeichnet, daß zur Beaufschlagung des Schermessers (11) oder der Teil-Schermesser (9) jeweils wenigstens vier Federn vorgesehen sind, von denen jeweils zwei auf der Seite einer Schneide (19,21) angreifen.

12) Schneidvorrichtung nach Anspruch 11, dadurch gekennzeichnet, daß die vier Federn durch zwei U-förmig gebogene, sich bevorzugt parallel zur Schneidrichtung (22) erstreckende und an der Federplatte (23) befestigte Blattfedern (24) gebildet sind, deren freie Schenkel das Schermesser (11) oder das betreffende Teil-Schermesser (9) beaufschlagen.

13) Schneidvorrichtung nach einem der Ansprüche 1. bis 12, dadurch gekennzeichnet, daß dem Schermesser (11) oder den Teil-Schermessern (9) jeweils ein Schnappmechanismus (39) zugeordnet ist, der das Schermesser (11) bzw. die Teil-Schermesser (9) in der jeweiligen Schwenkendstellung zu halten sucht.

14) Schneidvorrichtung nach einem der Ansprüche 1 bis 13, dadurch gekennzeichnet, daß das Schermesser (11) oder die Teil-Schermesser (9) am Ende des Schneidhubes automatisch in ihre jeweils andere Schwenkendstellung verschwenkt werden.

15) Schneidvorrichtung nach Anspruch 13 u.14, dadurch gekennzeichnet, daß bevorzugt verstellbare Anschläge (45) vorgesehen sind, die am Ende des Schneidhubes das Schermesser (11) oder die Teil-Schermesser (9), die Federplatte (23) oder bevorzugt den Steuernocken (25) über den Totpunkt (Federnocken 42) hinaus verstellen.

16) Schneidvorrichtung nach einem der Ansprüche 13 bis 15, dadurch gekennzeichnet, daß der Schnappmechanismus (39) einen mittel- oder unmittelbar am Schermesser (11) oder Teil-Schermesser (9) befestigten Steuernocken (25) umfaßt, der einen Totpunkt (Federnocken 42) zu überfahren vermag.

17) Schneidvorrichtung nach Anspruch 16, dadurch gekennzeichnet, daß der Totpunkt durch einen elastisch ausweichbaren Federnocken (42) oder dergleichen gebildet ist.

18) Schneidvorrichtung nach Anspruch 16 oder 17, dadurch gekennzeichnet, daß der Steuernocken (25) an der Federplatte (23) befestigt und der Federnocken (42) mittelbar oder unmittelbar im Verschiebeblock (7) gelagert ist.

19) Schneidvorrichtung nach einem der Ansprüche 1 bis 18, dadurch gekennzeichnet, daß verstellbare Anschläge (45) für das Schermesser (11) oder die Teil-Schermesser (9) bzw. für die Federplatte (23) oder den Steuernocken (25) vorgesehen sind.

2o) Schneidvorrichtung nach Anspruch 19, dadurch gekennzeichnet, daß die Anschläge (45) durch Stellschrauben oder dergleichen gebildet sind, die von beiden Seiten gegen den Steuernocken (25) wirken.

21) Schneidvorrichtung nach Anspruch 2o, dadurch gekennzeichnet, daß der Steuernocken (25) in eine Aussparung (43) des Verschiebeblocks (7) hineinreicht, und die Stellschrauben (45) Seitenwände (44) des Verschiebeblocks (7) durchfassen.

22) Schneidvorrichtung nach einem der Ansprüche 7 bis 21, dadurch gekennzeichnet, daß für alle Teil-Schermesser (9) eine gemeinsame Federplatte (23) vorgesehen ist.

23) Schneidvorrichtung nach einem der Ansprüche 1 bis 22, dadurch gekennzeichnet, daß der Schneidhub (H) um wenigstens daß Maß der Messerbreite (b) über die mit Bauelementen bestückte Fläche oder über die größtmögliche Be-stückungsfläche (1) hinausgeht.

FIG. 1

FIG. 2

1/2

014 1279

# FIG. 3